(19)
Europäisches Patentamt
European Patent Office
Office européen des brevets

(11) **EP 1 862 280 A1**

(12) **EUROPEAN PATENT APPLICATION**
published in accordance with Art. 158(3) EPC

(43) Date of publication:
**05.12.2007 Bulletin 2007/49**

(21) Application number: **05822856.0**

(22) Date of filing: **27.12.2005**

(51) Int Cl.:
*B28D 5/00* (2006.01)       *B23K 26/00* (2006.01)
*B23K 26/08* (2006.01)       *C03B 33/037* (2006.01)
*C03B 33/09* (2006.01)       *H01L 21/301* (2006.01)

(86) International application number:
**PCT/JP2005/023940**

(87) International publication number:
**WO 2006/070825 (06.07.2006 Gazette 2006/27)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **28.12.2004 JP 2004381259**

(71) Applicant: **Mitsuboshi Diamond Industrial Co., Ltd.**
**Suita-city, Osaka Pref. 564-0044 (JP)**

(72) Inventors:
• **UENO, Tsutomu c/o MITSUBOSHI DIAMOND INDUSTRIAL**
**Osak a; 5640044 (JP)**

• **OTODA, Kenji c/o MITSUBOSHI DIAMOND INDUSTRIAL**
**Osaka; 5640044 (JP)**
• **YAMAMOTO, Koji c/o MITSUBOSHI DIAMOND INDUSTRIAL**
**Osa ka; 5640044 (JP)**

(74) Representative: **TBK-Patent**
**Bavariaring 4-6**
**80336 München (DE)**

(54) **METHOD FOR CUTTING BRITTLE MATERIAL SUBSTRATE AND SUBSTRATE CUTTING SYSTEM**

(57)    An object of the present invention is to provide a method of scribing and breaking a substrate made of a brittle material by which good-quality cutting surface of the substrate can be obtained without any defects such as chippings on the substrate.

The method comprises (a) the first scribing step in the first direction by controlling the relative moving velocity and output power of the laser beam so that local volume shrinkage and local tensile stress can be generated in the vicinity of the formed first scribed line, (b) the second scribing step in the second direction of forming locally trigger cracks, which use tensile stress in the vicinity of the first scribed line and work as a starting point in the second direction, in the vicinity of the intersection of a scribed line in the first direction with a scribed line in the second direction, (c) the first breaking step of breaking the substrate along the first scribed line in the first direction, and (d) the second breaking step of breaking the substrate along the second scribed line in the second direction after the first breaking step and performing the breaking from the trigger that works as a starting point of breaking.

Fig. 5

**Description**

**FIELD OF THE INVENTION**

The present invention relates to a method of scribing and breaking a substrate made of a brittle material and a system for scribing and breaking a substrate, wherein a mother substrate made of a brittle material such as glass, ceramics of sintered material, single crystal silicon, sapphire, semiconductor wafer, or ceramics substrate, is scribed and broken after heated lower than a melting temperature by using a laser beam to form a scribed line with a vertical crack, and particularly, relates to a method of scribing and breaking a substrate made of a brittle material and a system for scribing and breaking a substrate, wherein vertical cracks in two directions intersecting each other are formed in a substrate made of a brittle material, and then the substrate is broken along the two directions.

**BACKGROUND OF THE ART**

Usually, a cutter wheel is pressed against a substrate of a brittle material and moved with rotation to form a scribed line, and the substrate is bent and broken in a direction perpendicularly to and along the formed scribed line to scribe and break the substrate.

For example, in the field of manufacturing a panel such as a liquid crystal display, a mother substrate made by overlapping two substrates is divided into small size of unit substrates by forming one or more of scribed line one by one in a first direction and a second direction intersecting each other (hereinafter referred to as intersectional scribing) and breaking the mother substrate along the formed scribed lines.

It is disclosed that, when the first and the second scribed lines intersecting each other are formed one by one in this order in a substrate made of a brittle material such as a glass substrate by using a cutter wheel, the scribing pressure for the second scribed line is made larger than that for the first scribed line to prevent defect of scribing (a phenomenon that there is generated a part where scribed line is not formed in the vicinity of the intersection point, when the second scribed line is formed intersecting with the first scribed line) in the vicinity of the intersection point.

Recently, there is practically used a method of scribing and breaking a substrate where the substrate is heated lower than the melting temperature by using a laser beam. In the method of scribing and breaking a substrate made of a brittle material by using a laser beam, a notched part (hereinafter referred to as a trigger crack) formed at the starting point of processing the substrate made of a brittle material is grown by thermal stress generated by irradiation of the laser beam, and the formed vertical crack is led to the finishing point of processing by moving the laser beam along the line to be scribed. Usually, when a substrate made of a brittle material is scribed with a cutter wheel, defect of the substrate tends to generate easily due to a mechanical stress applied to the substrate by the cutter wheel, and crack or the like is generated due to the above-mentioned defect when breaking is carried out. On the other hand, when a laser beam is used to scribe a substrate made of a brittle material, since thermal stress is used and the substrate is not pressed with a tool, a smooth sectional face without chipping is formed after scribing and breaking, and the strength of the substrate is maintained. That means, since scribing of a substrate made of a brittle material by using the laser beam is a process without mechanical contact, the above-mentioned latent defect is prevented to be generated, a defect such as chipping in a substrate made of a brittle material is prevented to be generated when breaking is carried out.

When scribed lines intersecting each other are formed by using a laser beam, after the first scribed line is formed in the first direction, a smaller depth of the second scribed line of a vertical crack than that of the first scribed line is formed in the second direction to prevent abnormal crack to be generated in the intersection point of the first scribed line and the second scribed line (see Patent Document 2).

Patent Document 1: Japanese Examined Patent Publication No. 1993-35689
Patent Document 2: Japanese Patent Publication No. 3370310

**DISCLOSURE OF THE INVENTION**

**PROBLEMS TO BE SOLVED BY THE INVENTION**

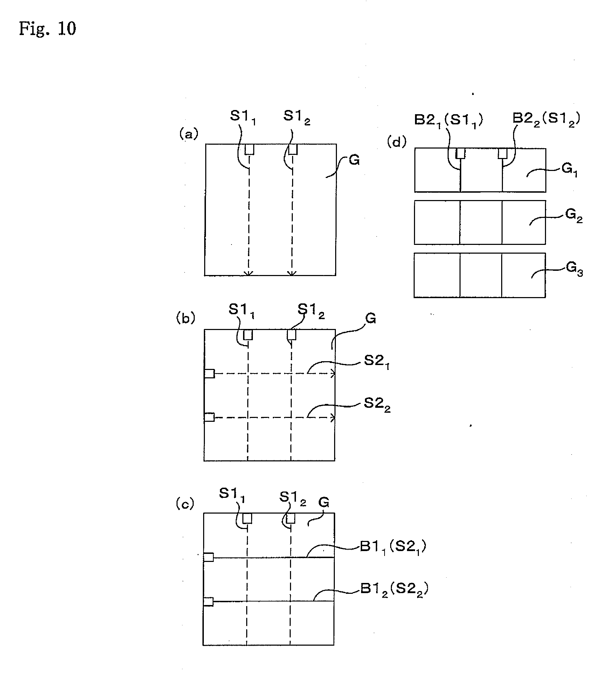

Fig. 10 is a figure to explain prior process of scribing and breaking a mother substrate along a scribed line after the scribed line is formed in the mother substrate by irradiation of a laser beam. In Fig. 10 (a), first scribed lines $S1_1$, and $S1_2$ are formed in the mother substrate G by scanning a laser beam at a velocity of V in a first direction. Then, as shown in Fig. 10 (b), second scribed lines $S2_1$, and $S2_2$ are formed by scanning the laser beam at the velocity of V in a second direction intersecting perpendicular by to the first scribed lines $S1_1$, and $S1_2$. Output power of the laser beam is constant in the formation of these scribed lines, and a trigger is initially formed at the edge of the substrate.

Next, as shown in Fig. 10 (c), the first breakings $B1_1$, and $B1_2$ are carried out by applying a load F to the mother substrate G along the second scribed lines $S2_1$, and $S2_1$. In this time, the mother substrate G is broken comparatively with ease along the second scribed line $S2_1$, and $S2_2$. Namely, since a notch acting as a trigger is formed at the one side edge of the scribed lines $S2_1$, and $S2_2$ formed on the mother substrate G, the substrate can be broken with a small load F.

Next, as shown in Fig. 10 (d), the second breakings $B2_1$, and $B2_2$ are carried out along the first scribed lines $S1_1$, and $S1_2$. In this time, among the substrates G1, G2, and G3, the substrate G1 has a trigger at the edge of the substrate formed before formation of a scribed line, and the substrate G3 has a trigger at the edge of the substrate formed naturally at the time of formation of a scribed line. Therefore, if the divided mother substrate G2 is tried to be broken by the method same as that of the first breakings $B1_1$, and $B1_2$ shown in Fig. 10 (c), at least the divided mother substrate G2 cannot be broken with ease along the first scribed lines $S1_1$, and $S1_2$ since at least the divided mother substrate G2 has no trigger. The second breakings $B2_1$, and $B2_2$ are needed to be carried out with applying a load at least the load F to break the mother substrate G2 forcibly along the first scribed lines $S1_1$, and $S1_2$. Particularly, when the thickness of the substrate is large (for example, the case of at least 2 mm thickness, but depending on the kind of the material), the load for breaking is large.

Usually, at the time of breaking, the load for breaking is set a load range by which breaking can surely be carried out, and as small as possible to suppress the impact given to the substrate so that a defect such as chipping is prevented from generating. When the divided mother substrates G1 to G3 are applied with a load larger than the load F and broken, a defect such as chipping tends to be generated in ease at the sectional plane formed by scribing and breaking (a sectional plane formed by scribing and breaking in the second direction) of the mother substrates G. On the other hand, if the first scribed line $S1_1$, and $S1_2$ are tried to be formed of a deep crack, a low moving velocity of a laser beam or high output power of a laser beam becomes need, and, as a result, there were problems that a moving velocity of a laser beam intimate in practical use cannot be given, quality of a plane formed by scribing and breaking after breaking is remarkably lowered.

Therefore, the present invention is intended to provide a method of scribing and breaking a substrate made of a brittle material, and a system for scribing and breaking a substrate capable of decreasing defects such as chipping generated on a plane formed by scribing and breaking and to give an excellent sectional plane formed by scribing and breaking of a substrate at the time of scribing and breaking a substrate made of a brittle material.

**MEANS FOR SOLVING THE PROBLEMS**

The method of scribing and breaking a substrate made of a brittle material of the present invention has been made to solve the above-mentioned problems, and is a method of scribing and breaking a substrate made of a brittle material wherein a substrate is irradiated with a laser beam relatively moving along one by one the first direction and the second direction intersecting each other on the substrate to be heated lower than the melting temperature and scribed lines of a vertical crack in the first direction and the second direction are formed one by one by thermal stress generated in the substrate; and the method comprising the following steps;

(a) The first direction scribing step: The first scribed line is formed by that relative moving velocity and/or output power of a laser beam is adjusted to generate local volume shrinkage and local tensile stress in the vicinity of the first scribed line. Usually, the vertical crack composing the first scribed line is a blind crack.

(b) The second direction scribing step: The second scribed line with a trigger crack for breaking to act as a starting point in the second direction breaking step is formed in the second scribed line and in the vicinity of the intersection point with the first scribed line by using tensile stress generated in the vicinity of the first scribed line. Usually, a vertical crack composing of the second scribed line other than a trigger crack for breaking is a blind crack, and of the trigger crack for breaking, is a visible crack.

For example, parameters of the relative moving velocity and/or output power of the laser beam in the first scribing step of forming the first scribed line is adjusted to make the energy density (ED) not lower than the predetermined threshold, the second scribed line can be formed so as to form locally trigger cracks for breaking; wherein ED is dfined by an equation set forth below,

$$ED = \text{Output power of the laser beam (W) / (Beam spot area } (\text{mm}^2) \text{ x Scribing velocity (mm/s))}.$$

Concretely, the trigger crack for breaking can be formed at the time of formation of the second scribed line by forming the first scribed line with adjusting the energy density (ED) in a range in which a scribed line can be formed and a range lower than the specific threshold. There is no limitation, but the energy density (ED) may be, for example, 0.016 to 0.022 J/mm$^2$ when the substrate made of a brittle material is a glass substrate such as soda glass substrate. The depth of the second scribed line may be shallower or deeper than the depth of the first scribed line. Therefore, the energy density (ED) of a laser beam for formation of the second scribed line may be decreased or increased in comparison with that for formation of the first scribed line.

(c) The first direction breaking step: The substrate is broken along the first scribed line.

(d) The second direction breaking step: The substrate is broken along the second scribed line after the first direction breaking step. For example, the load applied to the substrate in the second direction breaking step may be same as or smaller than that for the first breaking step.

The following system for scribing and breaking a substrate is also included in the present invention.

A system for scribing and breaking a substrate comprises

(A) a laser beam irradiation unit to irradiate a laser beam, a laser beam scanning unit to move the laser beam irradiation unit relatively to the substrate made of a brittle material, a changing unit for the laser beam scanning direction to change the scanning direction of the laser beam against the substrate, the scribing unit to forming a scribed line by irradiating and scanning the laser beam to the substrate,

(B) a breaking unit to break the substrate along a scribed line formed on the substrate, and

(C) a controller unit to control the scribing unit and the breaking unit,

wherein the controller unit controls the scribing unit to adjust the relative moving velocity and/or output power of the laser beam to generate volume shrinkage and tensile stress locally in the substrate in the step of forming the first scribed line, to change the scanning direction of the laser beam by the changing unit for the laser beam scanning direction after forming the first scribed line to form the second scribed line intersecting with the first direction, and then controls the breaking unit to break the substrate along the second scribed line after breaking along the second scribed line.

In the present invention, a substrate of a brittle material is typically a glass substrate, but the other substrates such as ceramics of sintered material, single crystal silicon, sapphire, semiconductor wafer, and ceramic substrate may also be included.

Such a substrate made of a brittle material includes a single substrate or a substrate of multiple substrates, and a substrate with a circuit pattern, a metal film forming an electrode, or a resin film. The present invention is particularly effective for scribing and breaking a substrate which requires a large pressing stress for breaking after scribing by using a usual method of scribing and breaking. Generally, a soda glass substrate is broken in comparative ease after scribing by using laser, but, for example, a soda glass substrate having a thickness of at least 2 mm (for example 2 to 5 mm) and used for a plasma display panel (PDP) requires a large pressing stress for breaking by using a usual method for scribing and breaking.

As concrete applications of a substrate made of a brittle material applied with a method and a system for scribing and breaking a substrate made of a brittle material of the present invention, exemplified are panels for a flat panel display such as a liquid crystal display panel, plasma display panel (PDP), organic EL display panel, and substrate for a projector. In the present invention, "local volume shrinkage of a substrate" means a phenomenon that non-crystalline material such as glass in a metastable state as original state shrinks in volume with heating etc. Tensile stress is generated in the substrate by cooling a surface of the substrate having local volume shrinkage.

In the present invention, it is the most preferable that two directions intersecting perpendicularly to each other when "the first direction and the second direction intersecting each other", but not limited to this case, and two directions at least forming intersection point are acceptable.

Relative movement of a laser beam may be carried out by moving the laser beam side or the substrate side, or moving the laser beam side in X direction (or Y direction) and moving the substrate side in Y direction (or X direction) in an XY two dimension orthogonalization coordinate system.

The formation of a vertical crack by thermal stress can be generated by room air cooling after heating by laser beam irradiation, but it is preferable to be generated more surly by cooling the substrate with blowing a coolant and generating positively thermal stress.

For example, a substrate can be broken by pressing along a scribed line and applying a bending moment around the scribed line as an axis. As pressing along a scribed line, preferable is applying shearing force on the scribed line by using a breaking bar having a power blade contacting to the substrate linearly, but not limited thereto. For example, the substrate may be pressed substantially by bending so that the pressed side of the substrate becomes caved in due to the pressing by the breaking bar.

According to the present invention, the first scribed line should be formed by irradiation of a laser beam after adjusting parameters of relative moving velocity at the time of scanning the laser beam or output power of the laser beam in the first scribing step (a) in the above first direction. The relative moving velocity at the time of scanning a laser beam (scribing velocity) may be, for example, within 50 to 150 mm/s. Also, the output power of the laser beam may be 100 to 200 W. The energy density (ED) of a laser beam may be within 0.016 to 0.022 J/mm$^3$. At this time, local tensile stress is generated in the vicinity in the first scribed line by local volume shrinkage. Owing to this tensile stress, the first scribed line is formed in the above-mentioned area. The crack is usually generated as a blind crack.

It is necessary that surface temperature on the substrate should be kept lower than the melting point by controlling the relative moving velocity of the laser beam and /or output power of the laser beam and it is also desirable for the limited range of temperature condition that the maximum temperature in the heating area should be as high as possible, that is, it bears favorable effects on generation of high tensile stress to increase the energy density (ED) of the laser beam as high as possible in the possible range of scribing (adjusting the maximum temperature higher than the predetermined threshold (i.e., limited value)).

In the second scribing step (b), scribing is performed in the second direction, and trigger cracks for breaking as a starting point of the second breaking in the second direction (as will hereinafter be described) are generated locally in the vicinity of an intersection point of the scribed lines in the first direction and in the second direction, using the tensile stress that is generated in the vicinity of the scribed line in the first direction.

In other words, the second scribed line is formed by scribing in the second direction, and the cracks which compose the second scribed line in the vicinity of the intersection point with the first direction (i.e. the area where tensile stress exists) and cracks of the second scribed line which is far from the intersection point (i.e. the area where tensile stress dose not exist) are different from each other in the characteristics of the cracks.

The former cracks have remained unclosed and turned out to be usually grossly-visible cracks in this area around, because the tensile stress existing in the vicinity of the first scribed line is released due to the cracks formed in the second direction.

These cracks serve as a trigger at the time of breaking.

On the other hand, the latter cracks are the cracks (usual blind cracks) which form such a scribed line as is formed in the first scribed line. Accordingly, local cracks generated in the vicinity of intersection point in the second scribed line will turn out to be trigger cracks.

In the first breaking step (c) in the first direction, the above-mentioned substrate is broken along the first scribed line in the first direction. That is, by breaking the substrate first in the first direction which is different from the second direction with triggers for breaking, trigger cracks for breaking remain at the edge of each substrate after the first breaking.

Finally, in the second breaking step (d) in the second direction, the above-mentioned substrate is broken along the second scribed line in the second direction, starting from the point of the trigger cracks.

### EFFECTS OF THE INVENTION

According to the method of scribing and breaking a substrate made of a brittle material of the present invention can be broken along the scribed line in the second direction at a smaller load than ever before, so defects on the substrates, such as chippings, are difficult to be generated, the high-quality breaking surface of the substrates can be obtained.

Thereto, according to this invention, during the second scribing step of forming the second scribed line in the second direction, trigger cracks for breaking for the second breaking step in the second direction are generated, an additional step of forming trigger cracks is unnecessary to be incorporated separately, this gives us possibility to simply the process in comparison with the other scribing and breaking processes including the step of forming a trigger crack.

### (Other Means for Solving Problems and Effects of the Means)

Vertical cracks composing scribed lines in the first direction and the second direction in the above scribing and breaking method are blind cracks, and trigger cracks for breaking may be visible crack. Hereby presence or absence of trigger formation (availability of visible cracks) can be checked by eyes and this simplifies to check the process whether triggers are formed or not.

In the above method of scribing and breaking a substrate, the practical load given to the substrates during the breaking step in the second direction may be the same as or lower than that during the breaking step in the first direction.

This serves to prevent the defects on the scribing and breaking surface of substrates.

The scribing and breaking system invented to solve the above problems from the other point of view is among the best system suitable for performing the above-mentioned scribing and breaking method and is composed of as follow;

(A) a scribing unit which irradiates with a laser beam a substrate in order to form a scribed line and which is composed of a laser beam irradiation unit with a predetermined output power, a laser beam scanning unit for moving the laser beam irradiation unit with the preset output power on a substrate at preset moving velocity and a changing unit for the laser beam scanning direction,

(B) breaking unit which performs breaking the said substrate with bending moment along the axis of a scribed line formed on the said substrate,

(C) controller unit by which the scribing unit and the breaking unit are controlled. The controller unit is constructed to control the scribing unit and the breaking unit, comprising the steps of generating local volume shrinkage in the substrate, forming a scribed line in the first direction by means of relative moving velocity of a laser beam and/or output power of a laser beam adjusted so that tensile stress can be generated, changing the scanning direction of the laser beam by a changing unit for the laser beam scanning direction, controlling the scribing unit so that a scribed line can be formed in the second direction intersecting with the first direction, and thereafter, after having broken along the first scribed line in the first direction, breaking along the second scribed line in the second direction.

## BRIEF EXPLANATION OF DRAWINGS

Fig. 1 is a block diagram showing the configuration of a system for scribing and breaking a substrate in one embodiment of the present invention.

Fig. 2 is a diagram showing configuration of a scribing unit in the system for scribing and breaking a substrate in Fig. 1.

Fig. 3 is a diagram showing configuration of a breaking unit in the system for scribing and breaking a substrate in Fig. 1.

Fig. 4 is a Flow chart of performing a method of scribing and breaking a substrate made of a brittle material in one embodiment of the present invention.

Fig. 5 is a process drawings for a method of scribing and breaking a substrate made of a brittle material in one embodiment of the present invention.

Fig. 6 is a drawing showing the state of generation of visible cracks in scribing step.

Fig. 7 is a diagram explaining the range of generation of visible cracks when parameters of moving velocity of a laser beam are set in the scribing step.

Fig. 8 is a photo showing the states of generation of visible cracks.

Fig. 9 is a drawing showing relations between energy density (ED) for scribing and energy density (ED) for intersectional scribing.

Fig. 10 is a drawing showing the process of a traditional method of scribing and breaking a substrate made of a brittle material.

## EXPLANATION OF NUMERALS

| | |
|---|---|
| 11 | chassis |
| 12 | slide table |
| 13 | ball screw |
| 14, 15 | guide rail |
| 16 | ball nut |
| 19 | pedestal |
| 21 | guide rail |
| 22 | ball screw |
| 23 | motor |
| 24 | ball nut |
| 25 | rotary mechanism |
| 26 | table |
| 31 | scribing head |
| 33 | optical holder |
| 34 | laser oscillator |
| 35 | lens optical system |
| 37 | position read mechanism |
| 38, 39 | CCD camera |
| 40 | cooling unit |
| 41 | cooling source |
| 42 | nozzle |
| 45 | trigger formation unit (Cutter wheel) |

| | |
|---|---|
| 52 | table |
| 59 | pedestal |
| 61 | guide rail |
| 62 | ball screw |
| 63 | motor |
| 64 | ball nut |
| 65 | rotary mechanism |
| 66 | table |
| 71 | breaking bar |
| 72 | pressure blade |
| 74 | lifting mechanism |
| 78,79 | CCD camera |
| 80 | position read mechanism |
| 100 | breaking unit for a substrates |
| 200 | scribing unit |
| 201 | laser beam irradiation unit |
| 202 | laser beam scanning unit |
| 205 | changing unit for laser beam scanning direction |
| 300 | breaking unit |
| 301 | adjustment unit for breaking bar position |
| 302 | breaking bar driving unit |
| 400 | controller unit |
| 500 | substrate transportation unit |

**BEST MODE TO EMBODY THE INVENTION**

Hereinafter the method of scribing and breaking a substrate made of a brittle material and the system for putting this method into practice will be described with referent to the accompanying drawings.

**(Apparatus Composition)**

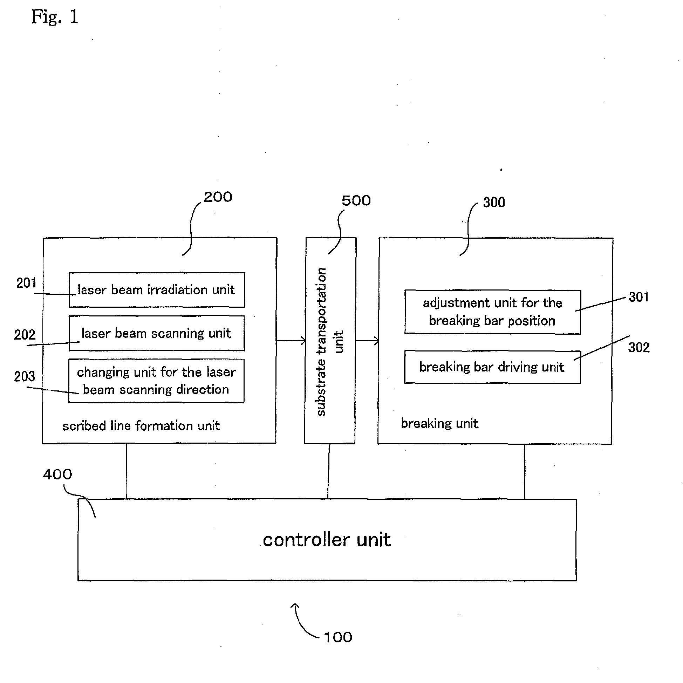

Fig. 1 is the block schematic diagram illustrating a system 100 for scribing and breaking a substrate, one embodiment to be used according to the present invention. The scribing and breaking system 100 thereof constitutes a scribing unit 200, a breaking unit 300 and a controller unit 400 controlling them in whole. The scribing unit 200 and the breaking unit 300 can be unified to be an integral structure, but in this working example the two units are separated. Accordingly, there is a substrate transportation unit 500 of widely known robot type between them. By means of a controller unit 400 transportation and inversion of substrates can be carried out from the scribing unit 200 to the breaking unit 300.

The scribing unit 200 works in the same motion under the controller unit 400. Hereinafter the description about the device configuration of the scribing unit 200 is given separately by block functions below: the laser beam irradiation unit 201, the laser beam scanning unit 202, the changing unit 203 for the laser beam scanning direction.

The laser beam irradiation unit 201 irradiates with the laser beam of preset output power with the help of input device which is not shown in the drawings (for example, a keyboard). At the moving velocity which is set beforehand by an input device (not illustrated) the laser beam scanning unit 202 locally heats a mother substrate G by the help of relative movement of the laser beam irradiation unit 201 along the mother substrate G. The changing unit 203 for the laser beam scanning direction changes the scanning direction by the laser beam scanning unit 202.

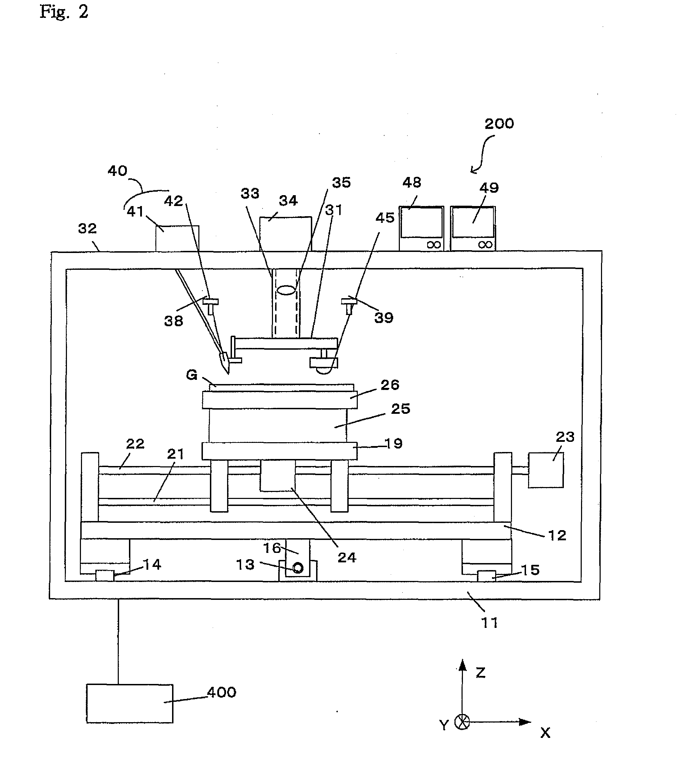

Next, each function of the above scribing units 200 will be described concretely. Fig. 2 shows concrete construction of the scribing unit 200 (scribing device) which is one of embodiments of the present invention.

The scribing unit 200 has a slide table 12 reciprocating in the Y-axis direction on a chassis with X-Y horizontal flat surface. This slide table 12 is designed to be supported by a pair of guide rails 14 and 15 oriented in parallel in the Y-axis direction on the chassis 11. In the intermediate position between the both guide rails 14 and 15 a ball screw 13 is mounted to be rotate by a motor (not illustrated), parallel to each guide rails 14 and 15. The ball screw 13 is able to rotate in either direction, forward or reverse. On the ball screw13 a ball nut 16 is threadably mounted.

The ball nut 16 is fixed not to rotate and not to be integrated with on the slide table 12 so as to slide in either direction forward r reverse, along the ball screw 13. Accordingly, the slide table 12, which is mounted integrally with the ball nut 16 , slides in Y-axis direction along the guide rails 14 and 15. Therefore, these components constitute the Y-axis drive mechanism.

On the slide table 12 a pedestal 19 is located in a horizontal position. The pedestal 19 is supported to slide along a pair of guide rails 21 parallel with the slide table 12 (there is one more guide rail of the same shape in the back in addition to the guide rail 21 shown in the drawing) Each of guide rails 21 is mounted in the X-axis direction perpendicular to the Y-axis direction along which the slide table moves. In the intermediate position between both the guide rails 21 a ball screw 22 is mounted in parallel to each guide rails 21 and can be rotatively driven by a motor 23 in either direction, forward or reverse.

A ball nut 24 is threadably mounted on the ball screw 22. The ball nut 24 is fixed non-rotatively and integrally on the pedestal 19 so as to move in either direction, forward and reverse, along the ball screw 22 when the ball screw 22 rotates forwardly or reversely. Accordingly, the pedestal 19 slides in the X-axis direction along the each of the guide rails 21. Therefore, these components constitute the X- axis drive mechanism.

On the pedestal 19 a table 26, on which a mother substrate G is put, is horizontally mounted. On the table 26 the mother substrate G is fixed by, for example, by a suction chuck. A reference mounting position (not illustrated in the drawing) related to X-axis direction is marked on the table 26 so that the substrate G, which is put accurately on the reference mounting position, can be moved precisely along the X-axis direction by the above slide mechanism (the X-axis mechanism). Furthermore, revolving velocity of the motor 23 is adjustable and moving velocity of the table 26 to the X-axis direction is adjustable by changing the revolving velocity of the motor.

A rotary mechanism 25 which can be driven by a motor (not illustrated) is set also on the pedestal 19 so that the direction of the mother substrate G on the table 26 can be changed. In this embodiment, the mechanism is constructed to rotate the mother substrate G on the mounting position by 90 degree of angle.

On the table 26, a scribing head 31 is located at an appropriate distance from the surface of the table 26. The scribing head 31 is supported in horizontal position to move up and down by a lifting mechanism (not illustrated) at the end of the bottom of an optical holder 33 located vertically. The upper end of the optical holder 33 is mounted to the bottom of surface of the mounting bracket 32 supported on the chassis 11. On the mounting bracket 32, a laser oscillator for oscillating a laser beam (for example, $CO_2$ laser) 34 is mounted so that the mother substrate G can be irradiated with the laser beam from the laser oscillator 34 through a lens optical system 35 supported within the optical holder 33.

A cooling unit 40 is mounted at the end of the scribing head 31. The cooling unit 40 is composed of a refrigerant source 41 (helium gas, $N_2$ gas, $CO_2$ gas etc.) and a jet nozzle 42 for the refrigerants supplied from the refrigerant source 41. By cooling locally the mother substrate G heated by irradiation of a laser beam, thermal stress appears and cracks are generated.

On the other end of the side of the scribing head 31, where the cooling unit 40 is installed on the opposite site, a trigger formation unit 45 (for example, a wheel cutter) which forms mechanically a starting point of a trigger is mounted. The trigger formation unit 45 generates a trigger (notch) at an edge of the mother substrate G when the trigger formation unit 45 contacts in close with pressure, bringing down the scribing head 31 temporarily, when it is directly below the edge of the mother substrate G.

Since the scribing unit 200 has such a concrete construction as described above, it bears the following relations with the function block composition already explained.: optical holder 33, laser oscillator 34 and lens optical system 35 correspond to the laser beam irradiation unit 201. X-axis direction drive mechanism composing the pedestal 19, the ball screw 22, the motor 23, the ball nut 24 correspond to the laser beam scanning unit 202 which scans the laser beam irradiated to the mother substrate G from scribing head 31. The rotary mechanism 25 corresponds to the changing unit 203 for the laser beam scanning direction, because the mechanism 25 can change the scanning direction of the laser beam by returning the mother substrate G.

Also, the Y- axis drive mechanism, composing the slide table 12, the ball screw 13, the motor which rotates the ball screw 13 (not illustrated), the bolt nut 16, is driven when the mother substrate G is moved in the Y-axis direction and is scribed along the X-axis direction more than once, i.e., the Y- axis drive mechanism is used for changing the position of the laser beam scanning unit 202 to Y-axis direction when the mother substrate G is scanned more than twice in the same direction and is divided into three pieces or more (not scanned along one direction one time).

On both sides of an optical holder 33 there is a position read mechanism composed of CCD cameras 38 and 39 photographing alignment marks formed inside the mother substrate G and recognizing the position of the alignment marks by a so-called image recognition method. Thanks to this position read mechanism any position of the mother substrate G mounted on the table 26 can be read, i.e., by using the data about the position of the mother substrate G through the position read mechanism and adjusting the positions by the above X- axis drive mechanism, Y- axis drive mechanism and also the rotary mechanism, the position of the mother substrate G can be fixed automatically. Images photographed by the CCD cameras 38 and 39 can be visibly confirmed on monitors 48 and 49. In addition, manual operation of the position of the mother substrate G can be carried out.

Next, a breaking unit 300 will be described below. As above in Fig.1, the breaking unit 300 (a breaking device) executes a series of actions under the controller unit 400 as well as the scribing unit 200. The breaking unit 300 comprising a adjustment unit 301 for the breaking bar position and a breaking bar driving unit 302 are described separately with respect to each function block.

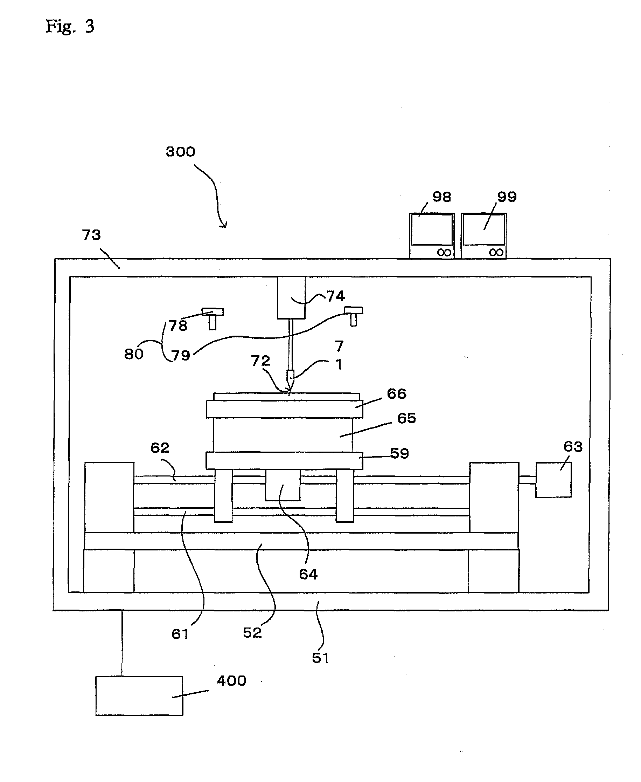

The adjustment unit 301 for the breaking bar position adjusts the relative position of a breaking bar 71 so that a pressure blade 72 (as will hereinafter be described in Fig. 3) can be located on a straight line or in its vicinity corresponding to the above-mentioned scribed line which is on the opposite side of the mother substrate G from the surface where the scribed line is generated (when a number of scribed lines exist, the pressure blade moves along them sequentially).

The breaking bar driving unit 302 approximates the pressure bar 72 of breaking bar 71 to the mother substrate G by driving the breaking bar 71 and burdens the mother substrate G.

Each function block of the above breaking unit 300 will be described according to the concrete driving mechanism. Fig. 3 shows the concrete construction of breaking unit 300 (a device for breaking), one of embodiments of the invention.

A pedestal 59 is arranged in a horizontal position on the table of a chassis 51. The pedestal 59 is supported to slide along a pair of guide rails 61 parallel to a slide table 52 (in addition to the guide rail 61 shown in the drawing there is one more guide rail of the same shape in the back). Each of guide rails 61 is mounted along the X-axis direction (horizontal direction). In the intermediate position between the both guide rails 61, a ball screw 62 is mounted in parallel to the each guide rails 61 and can be rotatively driven by a motor 63 in either direction, forward or reverse.

On the ball screw 62A, a ball nut 64 is mounted in threaded condition. The ball nut 64 is fixed non-rotatively and integrally on the pedestal 59 so as to move in either direction, forward and reverse, along the ball screw 62 when the ball screw 62 rotates forwardly or reversely. Accordingly, the pedestal 59 slides in the X-axis direction along the each of the guide rails 61. Therefore, an X- axis drive mechanism is composed of these components.

On the pedestal 59 a table 66, on which a mother substrate G is put, is located in a horizontal position. On the table 66, the mother substrate G is fixed by, for example, a suction chuck. A reference mounting position (not illustrated in the drawing) related to the X-axis direction is marked on the table 66 so that the mother substrate G, which is put accurately on the reference mounting position, can be moved precisely along the X-axis direction by the above slide mechanism (X-axis drive mechanism).

A rotary mechanism 65 which can be driven by a motor (not illustrated) is arranged also on the pedestal 59 so that the direction of the mother substrate G on the table 66 can be changed. In this embodiment, the mechanism is constructed to rotate the mother substrate G on the mounting position by 90 degree of angle.

On the table 66, breaking bar 71 is located at an appropriate distance from the surface of the table 66. The breaking bar 71 is composed of longitudinal rods. The breaking bar is mounted at the end of piston rod of a lifting mechanism 74 supported by flame 73 and moves up and down by the lifting mechanism 74. The bottom of the breaking bar 71 has an aciform pressure blade 72. When the lifting mechanism 74 runs, the aciform pressure blade goes down and presses the mother substrate G on the table 66.

On both sides of breaking bar 71, there is a position read mechanism composed of CCD cameras 78 and 79 photographing alignment marks formed inside the mother substrate G and triggers generated at an edge of the substrate at the time of formation of scribed line and recognizing the position of the alignment marks by a so-called image recognition method. Due to this position read mechanism 80 the position of the mother substrate G mounted on the table 66 can be read out. And, by driving X-axis drive mechanism on the base of images photographed by the position read mechanism 80, the pressure blade 72 can be managed to move along the scribed line of the mother substrate G.

Images photographed by the CCD cameras 78 and 79 can be visibly confirmed on monitors 98 and 99.

Since the breaking unit 300 has such a concrete construction as is described above, it bears the following relations with the function of block composition already explained: the X-axis direction drive mechanism (the pedestal 59, the ball screw 62, the motor 63 and the ball nut 64), the rotary mechanism 65 and the position read mechanism 80 (CCD cameras 78 and 79)- they correspond to the adjustment unit 301 for the breaking bar position which adjusts the position of the pressure blade 72 to follow along the scribed line.

Moreover, the lifting mechanism 74 corresponds to the breaking bar driving unit 302 which presses the breaking bar 71 against the mother substrate G.

Next, a controller unit 400 will be described. The controller unit 400 is composed of such a computer system as CPU, memories etc. The application soft stored in the memory runs and controls each of the above scribing unit 200 and breaking unit 300 and executes actions of the method of scribing and breaking of the present invention (as will hereinafter be described in detail according to the flow charts).

In this embodiment, a substrate transportation unit 500, which inverts substrates and feeds them from the scribing unit 200 to the breaking unit 300, is adopted. The controller unit 400 controls the substrate transportation unit 500, which is enable to invert the mother substrates G and feed them from the reference mounting position of the scribing unit 200 to the reference mounting position of the breaking unit 300.

**(Example of Operation)**

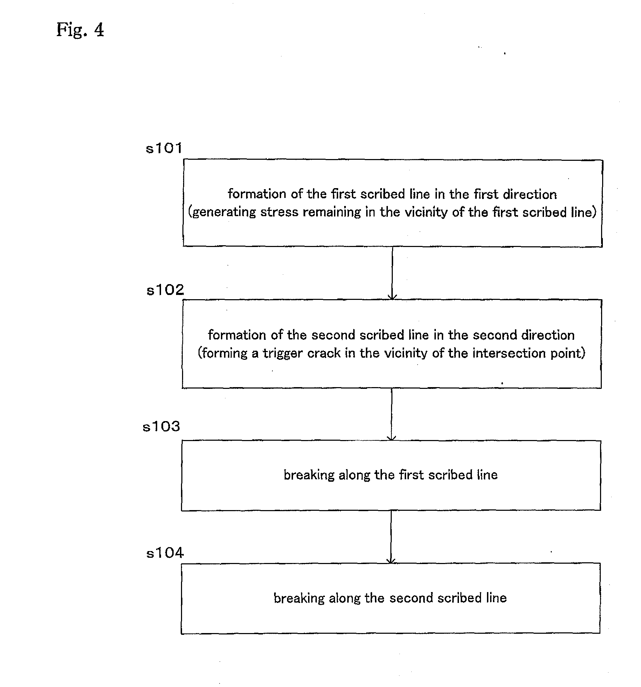

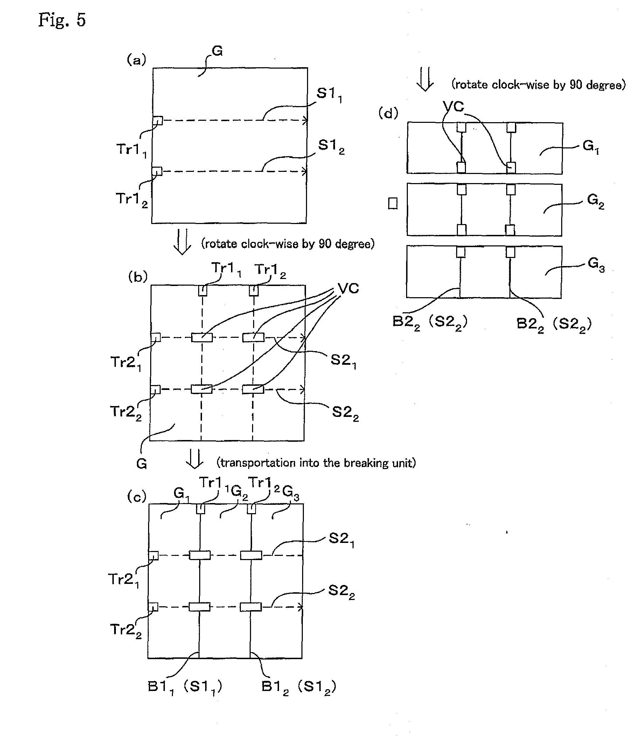

Operations for scribing and breaking substrates by using the above breaking system will be outlined below in accordance with the flow chart in Fig.4 and the drawing in Fig.5.

Parameters of output power of the laser beam irradiation unit 201 and the moving velocity of the laser beam scanning unit 202 are to be inputted in advance. The following two conditions are to be set on the experimental basis; the maximum temperature of the mother substrate G in the irradiated area of a laser beam must be as high as possible (i.e., the condition on which the available irradiation energy density of a laser beam is as high as possible) and must be less than the melting point of the mother substrate G (available range of scribing). When the first scribed lines $S1_1$, and $S1_2$ are formed, relative moving velocity and/or output power of a laser beam is to be set so that local volume shrinkage and local tensile stress can be generated in the vicinity of the first scribed lines $S1_1$, and $S1_2$.

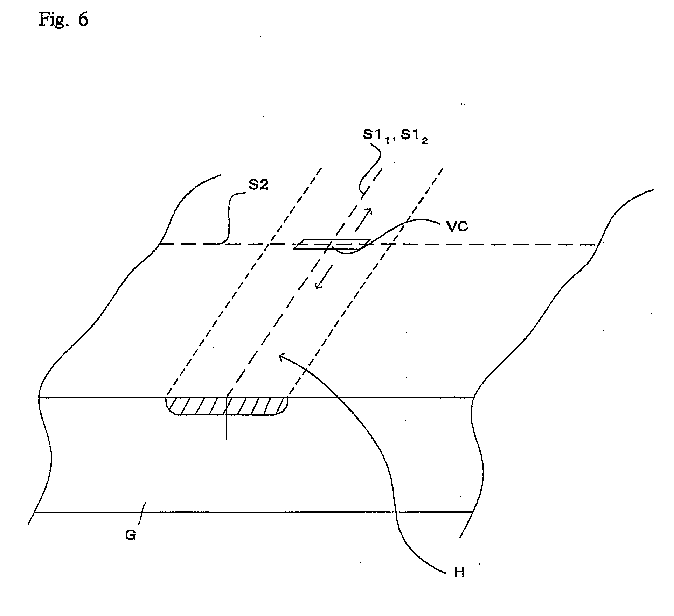

After parameters of the laser beam are set, the mother substrate G to be scribed and broken is put on the reference mounting position of the scribing unit 200. The mother substrate G is irradiated with a laser beam through the laser beam irradiation unit 201. As shown in Fig. 5 (a), scribed lines $S1_1$ and $S1_2$ (s101) are scanned and generated in the first direction on the glass mother substrate. At this time, blind cracks are generated along the scribed lines $S1_1$ and $S1_2$, and also the areas H where tensile stress remains, as shown in Fig. 6, are generated. By means of the trigger formation unit 45 in Fig. 2, triggers $Tr1_1$, and $Tr1_2$ are also formed at the edge of the mother substrate G on the beginning side of scanning.

Then, the preparation for scribing step in the second direction perpendicular to the first direction is made by rotating the mother substrate G and the table 26 clock wise at 90 degree of angle by the rotary mechanism 25.

According to the same procedure as in the first direction, the scribed lines $S2_1$ and $S2_2$ (s201) are formed in the second direction, as shown in Fig. 5 (b). Herewith, blind cracks are generated along the scribed lines $S2_1$ and $S2_2$, and also triggers $Tr2_1$, and $Tr2_2$ are generated at edges of the mother substrate G. As shown in Fig. 5 and also in Fig. 6, visible cracks VC working as triggers are generated in the area H in which tensile stress remains in the vicinity of intersection point where the scribed lines $S1_1$, and $S1_2$ and the scribed lines $S2_1$, and $S2_2$ are mutually-perpendicular.

Then, the mother substrate G with the scribed lines $S1_1$, $S1_2$, $S2_1$, and $S2_2$ is transferred to the reference mounting position of the breaking unit 300 by a transportation unit 500 for the following breaking step.

By the help of the adjustment unit 301 for the breaking bar position, the position of the pressure blade 72 is adjusted so that the scribed line $S1_1$ of the mother substrate G in the first direction should be located just under the pressure blade 72 of breaking bar 71 and then should be pressed against and be broken by driving the breaking bar driving unit 302 (s103). The mother substrate G is scribed and broken along the break line $B1_1$ in the first direction by the given load. At the edge of the mother substrate G, the trigger $T1_1$ is already generated before the scribed line $S1_1$ is formed. This accelerates and realizes breaking easily and simply at a small load. Then, the mother substrate G is moved in the X-axis direction by the adjustment unit 301 for the breaking bar position. When the scribed line $S1_2$ in the first line is broken in the same way, the mother substrate G is scribed and broken along $B1_2$. Hereby, the mother substrate G becomes the partially broken mother substrates, which are divided into strips G1, G2, and G3.

After that, the preparation for breaking step in the second direction perpendicular to the first direction is made by rotating the divided substrates G1, G2, and G3 clock wise by 90 degree of angle by the adjustment unit 301 for the breaking bar position.

By the help of the adjustment unit 301 for the breaking bar position, the position of the pressure blade 72 is adjusted so that the scribed line $S2_1$ of the mother substrates G1, G2, and G3 in the second direction should be located just under the pressure blade 72 of the breaking bar 71 and then the substrate G1, G2, and G3 should be pressed against and be broken by driving the breaking bar driving unit 302 (s104). The divided mother substrates G1, G2, and G3 are broken by a load along the break line $B2_1$ in the second direction. As the visible cracks VC working as triggers are already generated in the divided mother substrates at this time, there are triggers generated at the each edge of three of the divided mother substrates G1, G2, and G3. This facilitates to break the substrates easily and simply at a small load.

Then, the mother substrates G1, G2, and G3 are moved in the X-axis direction by the adjustment unit 301 for the breaking bar position. The mother substrates G1, G2, and G3 are broken along breaking line $B2_2$, when the same operation is done to the second scribed line $S2_2$ in the second direction. Since visible cracks VC working as triggers are formed at the edge of the divided mother substrates G1, G2 and G3, the substrates also can be broken at a small load easily and simply.

Because a large load is not given to the surface of substrates to be broken in the above step, there are little defects such as chippings on the edge face of the provided nine (9) pieces of the unit substrates.


**(Another Example of Operation)**

When the method of scribing and breaking of the present invention is put in execution, as mentioned above, formation of trigger cracks for breaking on the mother substrates is necessary during the scribing step. The availability of formation of the trigger cracks for breaking will be described on the base of experimental data.

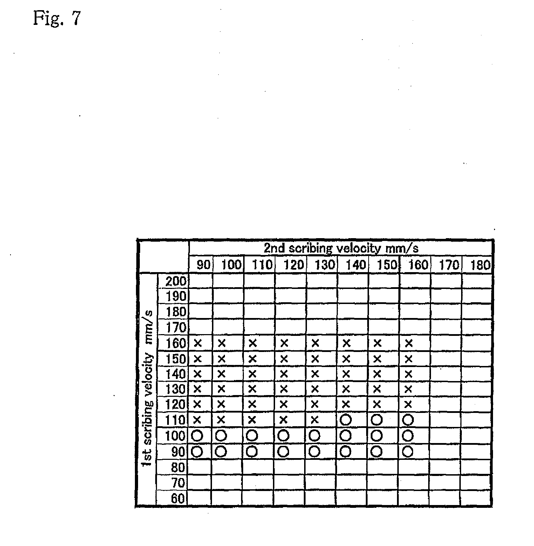

Fig.7 is the data which show the range of visible crack formation during the change of the moving velocity of a laser beam: moving velocity of scribing step (data indicated in rows in Fig. 7) in the first direction (the first scribing) and moving velocity of scribing step (data indicated in the columns in Fig. 7) in the second direction (the second scribing). Moving velocity of the laser beam changes within 90 to 160mm/s.

The material is soda glass with thickness of 2.8 mm and output power of the laser beam is set to be 170 W (fixed). In any case, the available maximum temperature is set lower than the melting point of substrates.

In Fig. 7, "O" indicates a case of forming visible cracks, and "X" indicates a case of not forming visible breaks. As seen in Fig. 7, in case the moving velocity of the laser beam during the first scribing is 90mm/s, 100mm/s respectively, i.e. when temperature of the laser beam in the irradiated area is lower than melting point and the maximum temperature is high, visible cracks are always formed without influence of moving velocity of a laser beam. The formation of these cracks is attributed to the fact that the cracks are generated during the second scribing step and remain opened due to release of residual stress when a substrate is heated to high temperature and residual stress is large.

In case the moving velocity of a laser beam during the first scribing is 100mm/s, visible cracks are generated only at the velocity of three variations 140 mm/s, 150 mm/s and 160 mm/s in the second direction, during the second scribing. This happened when the moving velocity in the second direction, 160 mm/s, 150 mm/s and 140 mm/s in decreasing order were measured. Visible cracks became generated at three velocities; 90 mm/s, 100 mm/s and 110mm/s in case velocity 90 mm/s, 100 mm/s and 110 mm/s in ascending order in the second direction were measured.

It results from the following facts: the data obtained at velocity 110 mm/s during the first scribing are the data obtained, when the second scribing (scribe intersecting with the first scribed line) was executed on one long first scribed line, i.e. as the number of the second scribing leaps upward on one scribed line, the above tensile stress, which had remained on the first scribed line, decreased gradually and visible cracks became not to be generated after the second scribing from the fourth time onwards in the present embodiment.

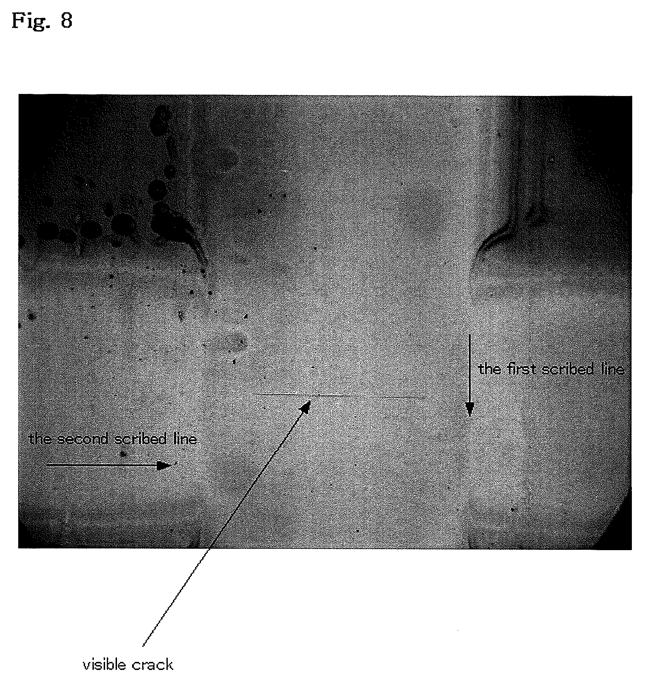

Fig. 8 shows the visible cracks formed on a glass substrate. It is confirmed that the substrates scribed under such conditions of forming visible cracks are easily broken by a small load, i.e., by the same load as is given in the process of the first direction, but in some cases less than that load.

For comparison, experiment with the substrates at the moving velocity of 150mm/s during the first scribing at the same load both in the first and the second directions was performed. Because no visible cracks that worked as triggers were generated, scribing and breaking of the substrates were generated in the second direction. The standard load alone, at which breaking in the first direction was possible, could not led to the scribing and breaking in the second direction.

When laser power is set to be 100 W in the first scribing, it lies on the dividing line whether visible cracks are generated or not. In this case, the load, necessary for scribing and breaking, is small, even if visible cracks are not observed.

It would appear that visible cracks for trigger of breaking can not be checked with eyes, but practically are generated: triggers for breaking are generated with a certainty and if the load in the first is at the same level as that in the second direction and scribing and breaking in the second direction is possible, it is understood that the triggers are generated in accordance with the present invention, even if they are unable to be checked with eyes.

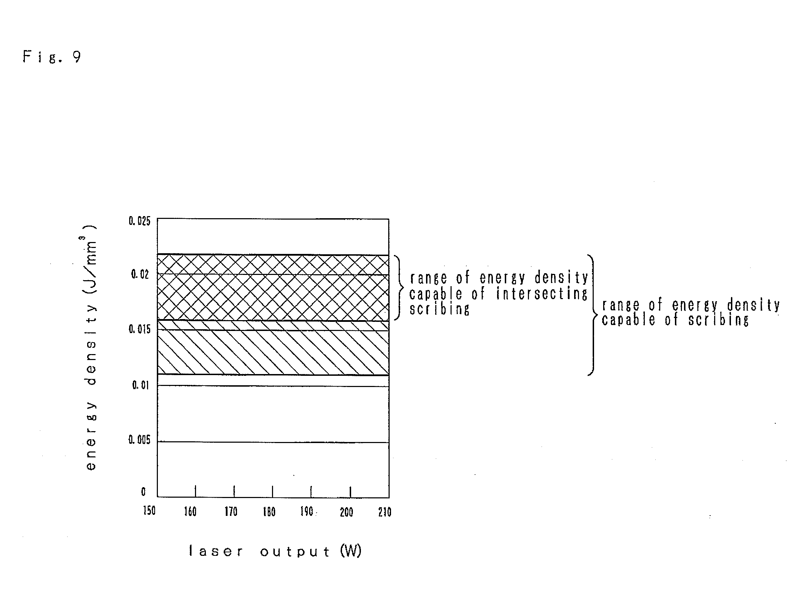

Fig. 9 is the graph showing the relation between the following (1) and (2):

(1) energy density (ED) of laser beam irradiation in the first scribing at the time of performing the intersection scribing of soda glass substrate with thickness of 2.8 mm, and
(2) energy density (ED) of laser beam irradiation in the first scribing (energy density (ED) necessary for intersection scribing) which is necessary to form trigger cracks (visible crack) for breaking in the second scribing step. As can be expected from Fig. 9, it was necessary that the energy density (ED) of laser beam irradiation should be set to be within 0.012 to 0.022 J/mm$^3$ in order to scribe the substrate at least in the range of 150 to 210 W of output power of the laser beam, while 0.016 to 0.022 J/mm$^3$ of the energy density (ED) of the laser beam irradiation was necessary to form trigger cracks (visible cracks) for breaking in the second scribing step.

**FIELD OF USABILITY IN INDUSTRY**

The present invention is available to be used when good-quality scribing and breaking of a substrate should be performed without any damages such as scratches, chippings in the substrate made of a brittle material.

**Claims**

1. A method of scribing and breaking a substrate made of a brittle material, wherein a substrate is irradiated with a laser beam relatively moving along one by one the first direction and the second direction intersecting each other on the substrate to be heated lower than the melting temperature, and scribed lines of a vertical crack in the first direction and the second direction are formed one by one by thermal stress generated in the substrate; and the method comprising

(a) the first scribing step of forming the first scribed line in the first direction wherein relative moving velocity and/or output power of the laser beam is adjusted to generate local volume shrinkage and local tensile stress in the vicinity of the first scribed line,
(b) the second scribing step of forming the second scribed line in the second direction with a trigger crack for breaking as a starting point in the second breaking step in the vicinity of the intersection point with the first scribed line in the second scribed line by using tensile stress generated in the vicinity of the first scribed line,
(c) the first breaking step of breaking the substrate along the first scribed line, and
(d) the second breaking step of breaking the substrate along the second scribed line after the first breaking step.

2. The method of scribing and breaking a substrate made of a brittle material of Claim 1, wherein the relative moving velocity and/or output power of the laser beam in the first scribing step of forming the first scribed line is adjusted to make the energy density (ED) not lower than a predetermined threshold; said energy density (ED) being defined by an equation set forth below:

$$ED \ (J/\ mm^3) = \text{Output power of the laser beam (W)} \ / \ (\text{Beam spot area } (mm^2) \ x \ \text{Scribing velocity (mm/s)}).$$

3. The method of scribing and breaking a substrate made of a brittle material of Claim 1, wherein the vertical cracks composing the first scribed line and the second scribed line other than the trigger crack for breaking are blind cracks, and the trigger crack for breaking is a visible crack.

4. The method of scribing and breaking a substrate made of a brittle material of Claim 1, wherein a load applied to the substrate in the second direction breaking step is same with or smaller than that in the first direction breaking step.

5. The method of scribing and breaking a substrate made of a brittle material of Claim 1 wherein the substrate made of a brittle material is a glass substrate, and the energy density of the laser beam (ED) for forming the first scribed line is adjusted to 0.016 to 0.022 J/mm$^3$; said energy density (ED) being defined by an equation set forth below: ED (J/ mm$^3$) = Output power of the laser beam (W) / (Beam spot area (mm$^2$) x Scribing velocity (mm/s)).

6. The method of scribing and breaking a substrate made of a brittle material of Claim 1 wherein the depth of the second scribed line is made deeper than the depth of the first scribed line.

7. The method of scribing and breaking a substrate made of a brittle material of Claim 1 wherein the irradiation energy per a unit area for forming the second scribed line is made larger than that for forming the first scribed line.

8. A system for scribing and breaking a substrate made of a brittle material comprising

(A) a laser beam irradiation unit to irradiate the substrate with a laser beam, a laser beam scanning unit to move the laser beam irradiation unit relatively to the substrate, a changing unit for the laser beam scanning direction to change the scanning direction of the laser beam against the substrate, the scribing unit to form a scribed line by irradiating the substrate with and scanning the laser beam,
(B) a breaking unit to break the substrate along a scribed line formed on the substrate, and
(C) a controller unit to control the scribing unit and the breaking unit,

wherein the controller unit controls the scribing unit to adjust the relative moving velocity and/or output power of the laser beam to generate local volume shrinkage and local tensile stress in the substrate in the step of forming the first scribed line, to change the scanning direction of the laser beam by the changing unit for the laser beam scanning direction after forming the first scribed line to form the second scribed line intersecting with the first direction, and then controls the breaking unit to break the substrate along the second scribed line after breaking along the second scribed line.

Fig. 1

## Fig. 2

Fig. 3

Fig. 4

s101

```
formation of the first scribed line in the first direction
(generating stress remaining in the vicinity of the first scribed line)
```

s102

```
formation of the second scribed line in the second direction
(forming a trigger crack in the vicinity of the intersection point)
```

s103

```
breaking along the first scribed line
```

s104

```
breaking along the second scribed line
```

Fig. 5

(a)

G

S1₁

Tr1₁

S1₂

Tr1₂

⇓ (rotate clock-wise by 90 degree)

(b)

Tr1₁  Tr1₂

VC

Tr2₁

S2₁

Tr2₂

S2₂

G

⇓ (transportation into the breaking unit)

(c)

G₁  Tr1₁ G₂  Tr1₂ G₃

S2₁

Tr2₁

S2₂

Tr2₂

B1₁ (S1₁)     B1₂ (S1₂)

⇓ (rotate clock-wise by 90 degree)

(d)

VC

G₁

□

G₂

G₃

B2₂ (S2₂)     B2₂ (S2₂)

Fig. 6

# EP 1 862 280 A1

Fig. 7

| | | 2nd scribing velocity mm/s | | | | | | | | | |
|---|---|---|---|---|---|---|---|---|---|---|---|
| | | 90 | 100 | 110 | 120 | 130 | 140 | 150 | 160 | 170 | 180 |
| 1st scribing velocity mm/s | 200 | | | | | | | | | | |
| | 190 | | | | | | | | | | |
| | 180 | | | | | | | | | | |
| | 170 | | | | | | | | | | |
| | 160 | × | × | × | × | × | × | × | × | | |
| | 150 | × | × | × | × | × | × | × | × | | |
| | 140 | × | × | × | × | × | × | × | × | | |
| | 130 | × | × | × | × | × | × | × | × | | |
| | 120 | × | × | × | × | × | × | × | × | | |
| | 110 | × | × | × | × | × | ○ | ○ | ○ | | |
| | 100 | ○ | ○ | ○ | ○ | ○ | ○ | ○ | ○ | | |
| | 90 | ○ | ○ | ○ | ○ | ○ | ○ | ○ | ○ | | |
| | 80 | | | | | | | | | | |
| | 70 | | | | | | | | | | |
| | 60 | | | | | | | | | | |

Fig. 8

the first scribed line

the second scribed line

visible crack

Fig. 9

Fig. 10

(a) S1₁ S1₂ G

(d) B2₁(S1₁) B2₂(S1₂) G₁ G₂ G₃

(b) S1₁ S1₂ G S2₁ S2₂

(c) S1₁ S1₂ G B1₁(S2₁) B1₂(S2₂)

| **INTERNATIONAL SEARCH REPORT** | International application No. |
|---|---|
| | PCT/JP2005/023940 |

A.  CLASSIFICATION OF SUBJECT MATTER
*B28D5/00*(2006.01), *B23K26/00*(2006.01), *B23K26/08*(2006.01), *C03B33/037*
(2006.01), *C03B33/09*(2006.01), *H01L21/301*(2006.01)

According to International Patent Classification (IPC) or to both national classification and IPC

B.  FIELDS SEARCHED

Minimum documentation searched (classification system followed by classification symbols)
*B28D5/00*(2006.01), *B23K26/00*(2006.01), *B23K26/08*(2006.01), *C03B33/037*
(2006.01), *C03B33/09*(2006.01), *H01L21/301*(2006.01)

Documentation searched other than minimum documentation to the extent that such documents are included in the fields searched
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| A | JP 2002-153984 A  (Seiko Epson Corp.), 28 May, 2002 (28.05.02), Column 12, line 47 to column 14, line 25 (Family: none) | 1-8 |
| A | JP 4-37492 A  (Soei Tsusho Kabushiki Kaisha), 07 February, 1992 (07.02.92), Page 3, upper right column, line 4 to lower left column, line 9 (Family: none) | 1-8 |
| A | WO 03/008352 A1  (Mitsuboshi Diamond Industrial Co., Ltd.), 30 January, 2003 (30.01.03), Page 3, lines 5 to 11 (Family: none) | 1-8 |

☐  Further documents are listed in the continuation of Box C.          ☐  See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 14 March, 2006 (14.03.06) | 20 March, 2006 (20.03.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5035689 B

- JP 3370310 B